(19) Europäisches Patentamt
European Patent Office
Office européen des brevets

(11) Veröffentlichungsnummer: **0 388 482 B1**

(12) **EUROPÄISCHE PATENTSCHRIFT**

(45) Veröffentlichungstag der Patentschrift: **06.07.94**

(51) Int. Cl.$^5$: **G03F 7/004**

(21) Anmeldenummer: **89104948.8**

(22) Anmeldetag: **20.03.89**

(54) **Lichtempfindliches Gemisch.**

(43) Veröffentlichungstag der Anmeldung:
**26.09.90 Patentblatt 90/39**

(45) Bekanntmachung des Hinweises auf die Patenterteilung:
**06.07.94 Patentblatt 94/27**

(84) Benannte Vertragsstaaten:
**DE FR GB IT NL**

(56) Entgegenhaltungen:
**EP-A- 0 171 748**
**DE-A- 2 718 130**
**FR-A- 2 197 189**
**US-A- 3 776 735**

**PATENT ABSTRACTS OF JAPAN, Band 8, Nr. 79 (P-267)[1516], 11. April 1984; & JP-A-58 223 147**

**RESEARCH DISCLOSURE, Band 174, Nr. 10, Oktober 1978, Seiten 38-42, Zusammenfassung Nr. 17454, Havant, GB; "Photosensitive materials suited for the production of positive photoresists"**

(73) Patentinhaber: **SIEMENS AKTIENGESELL-SCHAFT**
**Wittelsbacherplatz 2**
**D-80333 München(DE)**

(72) Erfinder: **Kühn, Eberhard**
**Bergstrasse 32**
**D-8551 Hemhofen(DE)**
Erfinder: **Hammerschmidt, Albert, Dr. Dipl.-Chem.**
**Coburger Strasse 47a**
**D-8520 Erlangen(DE)**
Erfinder: **Schmidt, Erwin**
**Elise-Späth-Strasse 23**
**D-8520 Erlangen(DE)**
Erfinder: **Ahne, Hellmut, Dr. Dipl.-Chem.**
**Heideweg 7**
**D-8551 Röttenbach(DE)**

EP 0 388 482 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein lichtempfindliches Gemisch aus einem Polymeren und einer photoaktiven Komponente sowie ein Verfahren zur Herstellung von Reliefstrukturen aus einem derartigen lichtempfindlichen Gemisch.

Photolithographisch aus lichtempfindlichen Gemischen, d.h. Photoresists, erzeugte Strukturen im µm-Bereich spielen bei der Herstellung hochintegrierter Schaltkreise eine Schlüsselrolle. Derartige Strukturen dienen nämlich generell als Masken bei einer Reihe von Prozeßschritten, die bei der Herstellung dieser Bauelemente durchlaufen werden, wie Ionenimplantation, Dotierung, Naß- und Trockenätzen.

Während die thermischen und mechanischen Eigenschaften der Reliefstrukturen sowie die Ätzresistenz durch die Auswahl der Harzbasis, d.h. des Polymeren, des zugrundeliegenden Resists beeinflußt werden können, wird die Photostrukturierbarkeit überwiegend von der photoaktiven Komponente bestimmt. Photoaktive Komponente und Polymeres müssen dabei allerdings soweit zusammenpassen, daß beispielsweise keine Entmischung des lichtempfindlichen Gemisches erfolgt und der belichtete Resist entwickelt werden kann. Die photoaktive Komponente muß darüber hinaus eine Reihe von Anforderungen erfüllen, wie gute Löslichkeit, Lagerbeständigkeit, Entwickelbarkeit mit ungiftigen, möglichst wäßrigen, d.h. ökologisch unbedenklichen Entwicklern, und hohe Empfindlichkeit, d.h. kurze Belichtungszeit, verbunden mit einem Bleichen der photoaktiven Komponente. Außerdem darf die Haftung des Polymeren auf dem Substrat nicht beeinträchtigt werden und es muß eine genaue Übertragung der Vorlage gewährleistet sein, verbunden mit einer guten Auflösung.

Zur Erzeugung feiner Strukturen können entweder Negativresists oder Positivresists verwendet werden (siehe beispielsweise: "Angew. Chem.", Bd. 94 (1982), Seiten 471 bis 485). Negativresists, bei denen das Strukturierungsprinzip im allgemeinen auf einer Vernetzung der belichteten Teile beruht, womit eine Erniedrigung der Löslichkeit verbunden ist, zeigen im Vergleich zu Positivresists eine geringere Auflösung, bedingt durch Quellung, und werden meist mit - ökologisch und wirtschaftlich ungünstigen - organischen Entwicklern entwickelt. Bei Positivresists, bei denen die Löslichkeit durch die Strahlungseinwirkung erhöht wird, wird der Löslichkeitsunterschied zwischen den belichteten und unbelichteten Teilen meist durch eine photochemisch induzierte Änderung der Polarität bewirkt, wodurch - ohne Quellung - eine wäßrig-alkalische Entwicklung ermöglicht wird.

Positivresists sind beispielsweise System mit o-Nitrobenzylesterverbindungen als photoaktive Komponente, welche bei der Belichtung in eine polare Carbonsäure und einen o-Nitrosobenzaldehyd zerfallen (a.a.O., Seite 482). Die o-Nitrosobenzaldehyde können im Resist jedoch zu farbigen Azoverbindungen koppeln und wirken somit einer Bleichwirkung entgegen. In Systemen, die nach dem Prinzip der sogenannten chemischen Verstärkung ("chemical amplification") arbeiten, werden photolytisch Protonen erzeugt, welche dann beispielsweise Phenolester zu den entsprechenden Phenolen verseifen. Die in diesen Systemen eingesetzten Photoinitiatoren, die sogenannten Crivello-Salze, wie Triarylsulfoniumsalze (siehe beispielsweise: "Polym. Eng. Sci.", Vol. 23 (1983), Seiten 953 bis 956), sind jedoch sehr korrosiv, was einer Verwendung in der Mikroelektronik entgegensteht.

Die vor allem in kommerziell vertriebenen Positivresists am häufigsten eingesetzte photoaktive Komponente basiert auf Sulfonsäureestern von Diazonaphthochinonen (a.a.O., Seite 481), die gutes Bleichverhalten mit kurzen Belichtungszeiten kombinieren. Derartige System weisen jedoch eine Reihe von Nachteilen auf, wie aufwendige Synthese, d.h. schlechte Verfügbarkeit, hoher Preis, brennbares bzw. explosives Verhalten (letzteres vor allem bei 4-Sulfonsäuren) und geringe thermische Beständigkeit, d.h. Zersetzung; außerdem lassen sich dicke Schichten (> 30 µm) nicht strukturieren.

Aufgabe der Erfindung ist es, das Angebot an wirksamen Photoresists zu erweitern, d.h. lichtempfindliche Gemische aus einem Polymeren und einer photoaktiven Komponente anzugeben, welche die an Photoresists gestellten Anforderungen im hohen Maße erfüllen und die Erzeugung feiner Strukturen erlauben.

Dies wird erfindungsgemäß dadurch erreicht, daß das Polymere Carbonsäureanhydrid- oder phenolische Hydroxylgruppen aufweist und daß die photoaktive Komponente ein N-substituiertes 1.4-Dihydropyridin oder 1.4-Dihydropyridinderivat folgender Struktur ist:

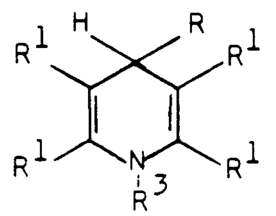

,

wobei die Reste $R^1$ gleich oder verschieden sind und folgende Bedeutung haben:

$R^1$ = H, $(CH_2)_n$-$CH_3$, OH, O-$(CH_2)_n$-$CH_3$, $(CF_2)_n$-$CF_3$, $C_6H_5$, O-$C_6H_5$, COOH, COO-$(CH_2)_n$-$CH_3$, CO-$(CH_2)_n$-$CH_3$, $(CH_2)_n$-O-$(CH_2)_m$-$CH_3$, $(CH_2)_n$-OH, $(CH=CH)_p$-CO-$CH_3$, F, Cl, Br oder J,
mit m = 0 bis 10, n = 0 bis 10 und p = 1 bis 4,

oder eines der beiden Paare ortho-ständiger Reste $R^1$ Bestandteil eines aromatischen oder olefinisch ungesättigten Sechsrings ist, und für den Rest R folgendes gilt:

R =

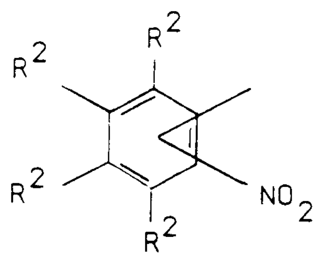

,

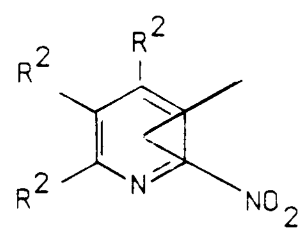

,

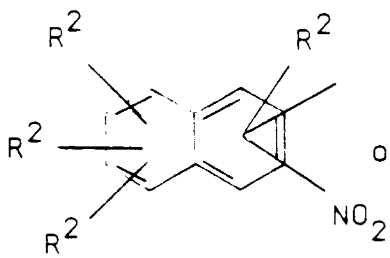

oder

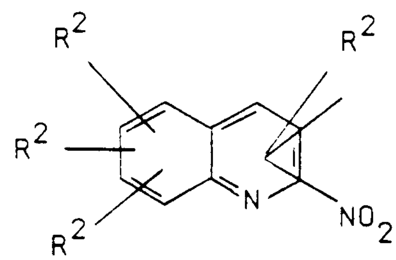

,

wobei die $NO_2$-Gruppe stets in ortho-Stellung zur Bindung zum Dihydropyridinring angeordnet ist und die Reste $R^2$ gleich oder verschieden sind und folgende Bedeutung haben:

$R^2$ = H, $(CH_2)_n$-$CH_3$, OH, O-$(CH_2)_n$-$CH_3$, $(CF_2)_n$-$CF_3$, $C_6H_5$, O-$C_6H_5$, COOH, COO-$(CH_2)_n$-$CH_3$, CO-$(CH_2)_n$-$CH_3$, $(CH_2)_n$-O-$(CH_2)_m$-$CH_3$, $(CH_2)_n$-OH, $NO_2$, F, Cl, Br oder J,
mit m = 0 bis 10 und n = 0 bis 10, und

$R^3$ Alkyl mit 1 bis 7 C-Atomen oder - gegebenenfalls substituiert - Cyclohexyl und Phenyl bedeutet.

Die lichtempfindlichen Gemische nach der Erfindung wirken entweder als Positivresist oder als Negativresist und zeichnen sich durch eine Reihe von hervorragenden Eigenschaften aus. So sind die Resistlösungen nicht nur lagerbeständig, sondern überraschenderweise lassen sich aus den Resistlösungen Schichten herstellen, die mit wäßrig-alkalischen, gegebenenfalls amin- oder ammoniakhaltigen Entwicklern strukturiert werden können. Eine ausgezeichnete Strukturierung ermöglichen dabei insbesondere Gemische, die phenolische Hydroxylgruppen aufweisende Polymere enthalten. Derartige lichtempfindliche Gemische wirken im übrigen als Negativresist, während Gemische mit Carbonsäureanhydridgruppen aufweisenden Polymeren als Positivresist fungieren. Die erfindungsgemäßen Photoresists zeigen ferner ein gutes, d.h. schnelles und vollständiges Bleichverhalten (bei 365 nm) sowie eine sehr gute Auflösung (< 1 µm) und sie lassen sich auch in dicken Schichten strukturieren. Außerdem ist die in diesen Resists eingesetzte photoaktive Komponente durch eine einfache Synthese kostengünstig verfügbar, ungiftig und gut löslich, und sie weise eine gute thermische Beständigkeit auf.

Durch die Erfindung wird eine neue Stoffklasse für den Einsatz als photoaktive Komponente in Resistsystemen verfügbar gemacht, nämlich substituierte N-alkylierte bzw. -arylierte 1.4-Dihydropyridine (und Derivate davon), insbesondere N-alkylierte bzw. -arylierte 4-(2'-Nitrophenyl)-1.4-dihydropyridine (und

entsprechende Derivate) folgender Struktur:

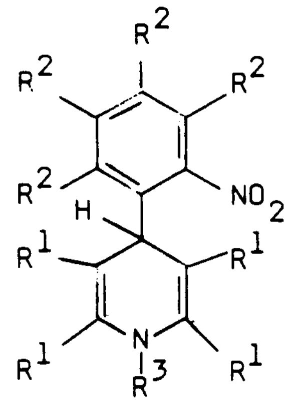

,

wobei die Reste R¹ und R² gleich oder verschieden sind und die Reste R¹, R² und R³ die vorstehend angegebene Bedeutung haben.

In 4-Stellung arylsubstituierte N-Alkyl-1.4-dihydropyridine sind an sich bekannt (siehe DE-PS 18 13 436 und DE-PS 19 23 990 sowie US-PS 3 946 028); sie finden in der Pharmazie Verwendung. Über die Photochemie von Verbindungen dieser Art wurde bislang aber noch nicht berichtet, d.h. es findet sich nicht der geringste Hinweis darauf, diese Verbindungen als photoaktive Komponente in lichtempfindlichen Gemischen einzusetzen.

In den lichtempfindlichen Gemischen nach der Erfindung finden Polymere mit Carbonsäureanhydridgruppen Verwendung. Diese Polymeren weisen vorzugsweise folgende Struktur auf:

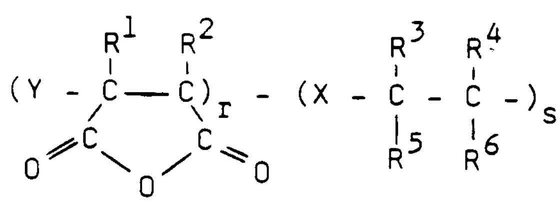

,

wobei folgendes gilt:

$r / r + s = 0$ bis 0,6 und $r + s = 4$ bis 3000;

X und Y sind gleich oder verschieden und stehen für eine Einfachbindung oder für -COO-, -CONH-, -CONHNH-, -OCOO-, -O-, $-SO_2-$ und -COOCO-;

die Reste $R^1$, $R^2$, $R^3$, $R^4$, $R^5$ und $R^6$ sind gleich oder verschieden und haben folgende Bedeutung:

H, $(CH_2)_n-CH_3$, $C_6H_5$, COOH, $COO-(CH_2)_n-CH_3$, $CO-(CH_2)_n-CH_3$, $Si[(CH_2)_n-CH_3]_3$, $Si(C_6H_5)_3$, $CH_2-Si(CH_3)_3$, $Si(OCH_3)_3$, $C_6H_4-OH$, $C_6H_4-(CH_2)_n-CH_3$, $C_6H_4-O-(CH_2)_n-CH_3$ und $(CH_2)_n-O-(CH_2)_m-CH_3$,

mit $m = 0$ bis 10 und $n = 0$ bis 10;

$R^1$ und $R^2$ bzw. $R^3$ und $R^4$ bzw. $R^5$ und $R^6$ können auch cyclisch aliphatisch oder aromatisch miteinander verbunden sein.

Die in den erfindungsgemäßen lichtempfindlichen Gemischen Verwendung findenden Polymeren mit phenolischen Hydroxylgruppen sind vorzugsweise Phenol-Formaldehyd-Kondensationsprodukte folgender Struktur:

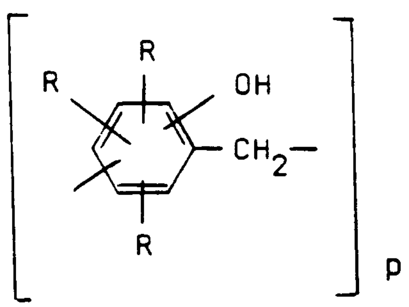

,

wobei folgendes gilt:

p = 10 bis 10000,

R = H, $(CH_2)_m$-OH, $(CH_2)_n$-$CH_3$, OH, O-$(CH_2)_n$-$CH_3$, $C_6H_5$ oder Halogen, d.h. F, Cl, Br und J, mit m = 1 bis 10 und n = 0 bis 10.

Ferner können vorteilhaft Hydroxypolyamide folgender Struktur eingesetzt werden:

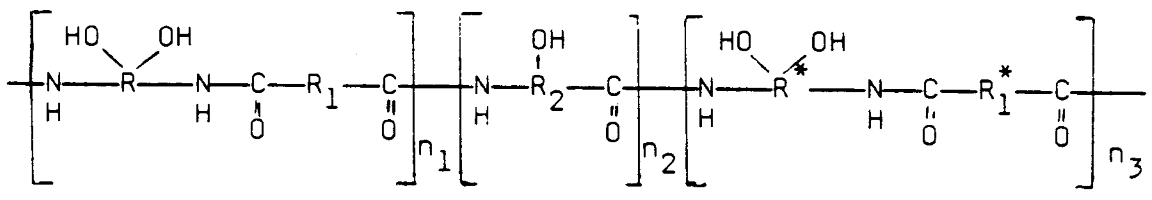
,

wobei R, R*, $R_1$, $R_1^*$ und $R_2$ aromatische Gruppierungen sind und bezüglich $n_1$, $n_2$ und $n_3$ folgendes gilt:

$n_1$ = 1 bis 100, $n_2$ und $n_3$ = 0, oder

$n_1$ und $n_2$ = 1 bis 100, $n_3$ = 0, oder

$n_1$, $n_2$ und $n_3$ = 1 bis 100 (mit R ≠ R* und/oder $R_1$ ≠ $R_1$*), oder

$n_1$ und $n_3$ = 1 bis 100, $n_2$ = 0 (mit R ≠ R* und/oder $R_1$ ≠ $R_1^*$ );

bzw. Hydroxypolyimide folgender Struktur:

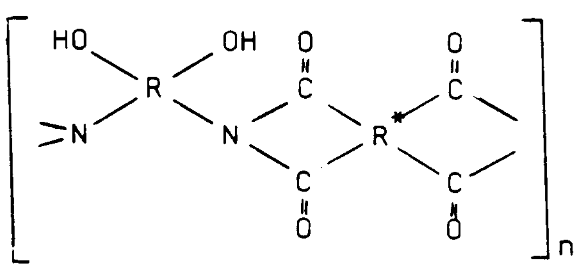
,

wobei R und R* aromatische Gruppierungen sind, die gleich oder verschieden sein können, und für n folgendes gilt:

n = 2 bis 100.

Da der Begriff "aromatische Gruppierungen" auch Heterocyclen, wie Furan und Thiophen, umfaßt, können die "phenolischen" Hydroxylgruppen auch an derartigen Gruppierungen sitzen.

Hydroxypolyamide der vorstehend genannten Art sind aus der DE-OS 37 16 629 bzw. aus der EP-OS 0 291 779 bekannt. Hydroxypolyimide der vorstehend genannten Art sind Gegenstand der europäischen Patentanmeldung Nr. 88117679.6 vom 24. Oktober 1988; R und R* haben dabei die in den beiden vorstehend genannten Druckschriften angegebene Bedeutung.

Bei den lichtempfindlichen Gemischen nach der Erfindung liegt das Masseverhältnis von Polymer zu photoaktiver Komponente im allgemeinen zwischen 20:1 und 1:20; vorzugsweise liegt dieses Masseverhältnis zwischen 10:1 und 1:10. Im übrigen können dabei auch Polymergemische vorliegen.

Zur Herstellung von Reliefstrukturen wird ein lichtempfindliches Gemisch nach der Erfindung in Form einer Schicht oder Folie auf ein Substrat aufgebracht und mit aktinischem Licht durch eine Maske belichtet oder durch Führen eines entsprechenden Lichtstrahls bestrahlt. Anschließend werden die belichteten bzw. bestrahlten Schicht- oder Folienteile herausgelöst oder abgezogen, und die dabei erhaltenen Strukturen werden dann bei erhöhter Temperatur getrocknet und gegebenenfalls getempert.

Das lichtempfindliche Gemisch, d.h. der Photoresist, kann vorteilhaft als Lösung in einem organischen Lösungsmittel auf das Substrat aufgebracht werden. Als Lösungsmittel wird dabei vorzugsweise N-Methylpyrrolidon oder Methoxypropylacetat verwendet. Daneben können aber auch andere organische Lösungsmittel mit ähnlichen Eigenschaften zum Einsatz gelangen, wie Dimethylformamid und N.N-Dimethylacetamid, sowie Gemische der genannten Lösungsmittel.

Beim erfindungsgemäßen Verfahren kann vorteilhaft ein Haftmittel und/oder ein Benetzungsmittel verwendet werden. Haft- bzw. Vernetzungsmittel können dabei der Photoresistlösung zugesetzt werden, sie können aber auch - vor der Beschichtung mit dem Photoresist - auf das Substrat aufgebracht werden. Die Photoresistlösung wird vorzugsweise mittels Schleuder- oder elektrostatischer Sprühtechnik auf das Substrat aufgebracht. Daneben können aber auch andere Beschichtungsmethoden, wie Tauchen, Bürsten und

Rollen, angewendet werden. Das Substrat besteht vorzugsweise aus Glas, aus Metall, insbesondere Aluminium, aus Kunststoff oder aus einem halbleitenden Material.

Anhand von Ausführungsbeispielen soll die Erfindung noch näher erläutert werden.

Beispiel 1

5 g eines käuflichen Novolaks (Bakelite LG724 CH4) werden mit 0,5 g N-Methyl-3.5-diacetyl-4-(2'-nitrophenyl)-1.4-dihydropyridin (zur Herstellung siehe: "Liebigs Ann. Chem.", Bd. 670 (1963), Seiten 57 ff.) in 20 g N-Methylpyrrolidon gelöst und die dabei erhaltene Lösung wird mittels einer Spritze durch ein 0,2 µm-Filter auf einen - mit einem käuflichen Haftvermittler auf der Basis von Aminosilan (KBM 602) behandelten - 3"-Siliciumwafer aufgebracht (1100 rpm, 20 s, Schichtdicke: 1,5 µm). Nach dem Trocknen (70 °C, 10 min, Umluft) wird 20 s durch eine Maske belichtet (Lampe MJB 55 mit 42 $mW/cm^2$) und anschließend 90 s mit einem wäßrig-alkalischen Entwickler (AZ 400 K, 1:5,5 mit Wasser verdünnt) entwickelt. Es werden feine Strukturen erhalten (Negativbild).

Beispiel 2

5 g handelsübliches Polyvinylphenol ($M_w$ = 9000 bis 11000) werden mit 1 g N-Methyl-2.6-dimethyl-4-(2'-nitrophenyl)-1.4-dihydropyridin-3.5-dicarbonsäuredimethylester (zur Herstellung siehe DE-PS 19 23 990) in 20 g N-Methylpyrrolidon gelöst und die dabei erhaltene Lösung wird mittels einer Spritze durch ein 0,2 µm-Filter auf einen - mit einem käuflichen Haftvermittler auf der Basis von Aminosilan (KBM 602) behandelten - 3"-Siliciumwafer aufgebracht (1500 rpm, 20 s, Schichtdicke: 1,44 µm). Nach dem Trocknen (70 °C, 10 min, Umluft) wird 10 s durch eine Maske belichtet (Lampe MJB 55 mit 42 $mW/cm^2$) und anschließend 20 s mit einem wäßrig-alkalischen Entwickler (AZ 400 K, 1:9 mit Wasser verdünnt) tauchentwickelt. Es werden feine negative Reliefstrukturen mit gutem Kontrast erhalten.

Beispiel 3

4 g einer Polybenzoxazol-Vorstufe, hergestellt aus 2.2-Di-(3-amino-4-hydroxyphenyl)-1.1.1.3.3.3-hexafluorpropan und 2.2-Di-(4-chlorcarbonylphenyl)-1.1.1.3.3.3-hexafluorpropan (zur Herstellung siehe: "Polym. Letters", Vol. 2 (1964), Seiten 655 ff.), werden mit 1 g N-Methyl-3.5-diacetyl-4-(2'-nitrophenyl)-1.4-dihydropyridin (zur Herstellung siehe: "Liebigs Ann. Chem.", Bd. 670 (1963), Seiten 57 ff.) in 20 g N-Methylpyrrolidon gelöst und die dabei erhaltene Lösung wird durch ein 0,2 µm-Filter auf einen - mit einem käuflichen Haftvermittler auf der Basis von Aminosilan (KBM 602) behandelten - 3"-Siliciumwafer aufgebracht (1000 rpm, 20 s, Schichtdicke: 1,9 µm). Nach dem Trocknen (70 °C, 15 min, Umluft) wird 20 s durch eine Maske belichtet (Lampe MJB 55 mit 42 $mW/cm^2$) und anschließend 80 s mit einem wäßrig-alkalischen Entwickler (NMD-3, 0,15 %) tauchentwickelt. Die dabei erhaltene Schicht wird in einem Diffusionsofen getempert: 1 h bei Raumtemperatur bis 170 °C, 1 h bei 170 bis 300 °C, 1 h bei 300 bis 400 °C, 1 h bei 400 °C und 4 h bei 400 °C bis Raumtemperatur. Es werden feine hochtemperaturbeständige negative Reliefstrukturen mit einem kleinen Temperpeak (9 %) erhalten.

Beispiel 4

3 g eines Styrol/Maleinsäureanhydrid-Copolymeren (Verhältnis 1:1) werden mit 1 g N-Methyl-2.6-dimethyl-4-(2'-nitrophenyl)-1.4-dihydropyridin-3.5-dicarbonsäuredimethylester (zur Herstellung siehe DE-PS 19 23 990) in 11 g N-Methylpyrrolidon gelöst und die dabei erhaltene Lösung wird durch ein 0,2 µm-Filter auf einen - mit einem käuflichen Haftvermittler auf der Basis von Aminosilan (KBM 602) behandelten - 3"-Siliciumwafer aufgebracht (1700 rpm, 20 s, Schichtdicke: 1,4 µm). Nach dem Trocknen (70 °C, 15 min, Umluft) wird 10 s durch eine Maske belichtet (Lampe MJB 55 mit 42 $mW/cm^2$). Die belichtete Schicht wird 75 s mit einem wäßrig-alkalischen Entwickler (AZ 400 K, 1:5 mit Wasser verdünnt, 0,2 % $NH_4OH$ v/v) entwickelt und nachfolgend getrocknet (120 °C, 10 min). Es werden feine positive Reliefstrukturen erhalten.

**Patentansprüche**

**1.** Lichtempfindliches Gemisch aus einem Polymeren und einer photoaktiven Komponente, **dadurch gekennzeichnet,** daß das Polymere Carbonsäureanhydrid- oder phenolische Hydroxylgruppen aufweist und daß die photoaktive Komponente ein N-substituiertes 1.4-Dihydropyridin oder 1.4-Dihydropyridinderivat folgender Struktur ist:

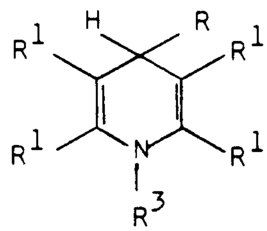

wobei die Reste $R^1$ gleich oder verschieden sind und folgende Bedeutung haben:

$R^1$ = H, $(CH_2)_n$-$CH_3$, OH, O-$(CH_2)_n$-$CH_3$, $(CF_2)_n$-$CF_3$, $C_6H_5$, O-$C_6H_5$, COOH, COO-$(CH_2)_n$-$CH_3$, CO-$(CH_2)_n$-$CH_3$, $(CH_2)_n$-O-$(CH_2)_m$-$CH_3$, $(CH_2)_n$-OH, $(CH=CH)_p$-CO-$CH_3$, F, Cl, Br oder J, mit m = 0 bis 10, n = 0 bis 10 und p = 1 bis 4,

oder eines der beiden Paare ortho-ständiger Reste $R^1$ Bestandteil eines aromatischen oder olefinisch ungesättigten Sechsrings ist,

und für den Rest R folgendes gilt:

R =

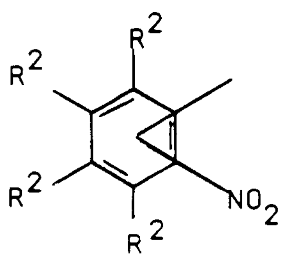 ,

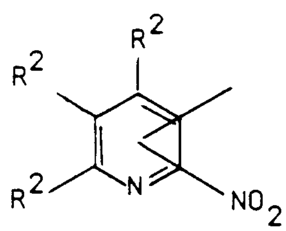 ,

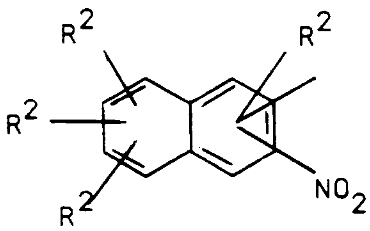 oder 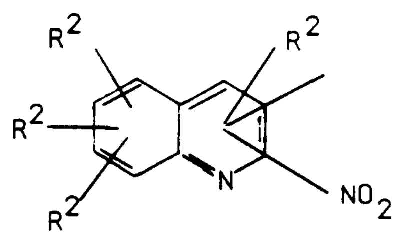 ,

wobei die $NO_2$-Gruppe stets in ortho-Stellung zur Bindung zum Dihydropyridinring angeordnet ist und die Reste $R^2$ gleich oder verschieden sind und folgende Bedeutung haben:

$R^2$ = H, $(CH_2)_n$-$CH_3$, OH, O-$(CH_2)_n$-$CH_3$, $(CF_2)_n$-$CF_3$, $C_6H_5$, O-$C_6H_5$, COOH, COO-$(CH_2)_n$-$CH_3$, CO-$(CH_2)_n$-$CH_3$, $(CH_2)_n$-O-$(CH_2)_m$-$CH_3$, $(CH_2)_n$-OH, $NO_2$, F, Cl, Br oder J, mit m = 0 bis 10 und n = 0 bis 10, und

$R^3$ Alkyl mit 1 bis 7 C-Atomen oder - gegebenenfalls substituiert - Cyclohexyl und Phenyl bedeutet.

2. Lichtempfindliches Gemisch nach Anspruch 1, **dadurch gekennzeichnet,** daß die photoaktive Komponente ein N-substituiertes 4-(2'-Nitrophenyl)-1.4-dihydropyridin oder ein entsprechendes Derivat folgender Struktur ist:

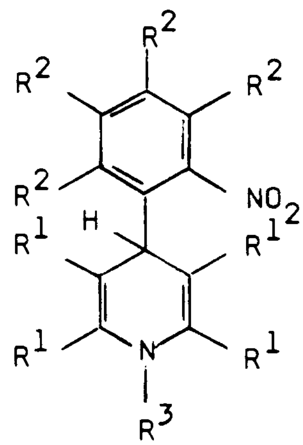

,

wobei die Reste $R^1$ und $R^2$ gleich oder verschieden sind und die Reste $R^1$, $R^2$ und $R^3$ die vorstehend angegebene Bedeutung haben.

**3.** Lichtempfindliches Gemisch nach Anspruch 1 oder 2, **dadurch gekennzeichnet,** daß das Polymere mit Carbonsäureanhydridgruppen folgende Struktur besitzt:

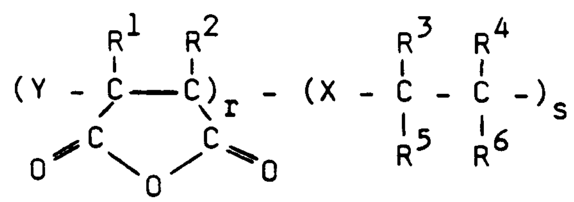

,

wobei folgendes gilt:
$r / r + s = 0$ bis 0,6 und $r + s = 4$ bis 3000;
X und Y sind gleich oder verschieden und stehen für eine Einfachbindung oder für -COO-, -CONH-, -CONHNH-, -OCOO-, -O-, $-SO_2-$ und -COOCO-;
die Reste $R^1$, $R^2$, $R^3$, $R^4$, $R^5$ und $R^6$ sind gleich oder verschieden und haben folgende Bedeutung:
H, $(CH_2)_n-CH_3$, $C_6H_5$, COOH, $COO-(CH_2)_n-CH_3$, $CO-(CH_2)_n-CH_3$, $Si[(CH_2)_n-CH_3]_3$, $Si(C_6H_5)_3$, $CH_2-Si-(CH_3)_3$, $Si(OCH_3)_3$, $C_6H_4-OH$, $C_6H_4-(CH_2)_n-CH_3$, $C_6H_4-O-(CH_2)_n-CH_3$ und $(CH_2)_n-O-(CH_2)_m-CH_3$,
mit m = 0 bis 10 und n = 0 bis 10;
$R^1$ und $R^2$ bzw. $R^3$ und $R^4$ bzw. $R^5$ und $R^6$ können auch cyclisch aliphatisch oder aromatisch miteinander verbunden sein.

**4.** Lichtempfindliches Gemisch nach Anspruch 1 oder 2, **dadurch gekennzeichnet,** daß das Polymere mit phenolischen Hydroxylgruppen ein Phenol-Formaldehyd-Kondensationsprodukt folgender Struktur ist:

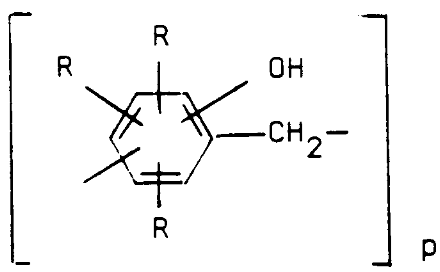

,

wobei folgendes gilt:
p = 10 bis 10000,
R = H, $(CH_2)_m-OH$, $(CH_2)_n-CH_3$, OH, $O-(CH_2)_n-CH_3$, $C_6H_5$ oder Halogen,

mit m = 1 bis 10 und n = 0 bis 10.

5. Lichtempfindliches Gemisch nach Anspruch 1 oder 2, **dadurch gekennzeichnet,** daß das Polymere mit phenolischen Hydroxylgruppen ein Hydroxypolyamid folgender Struktur ist:

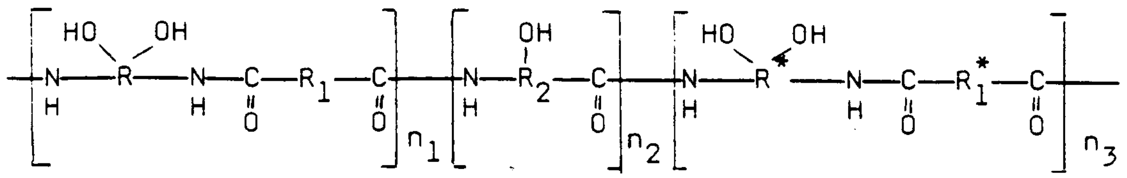 ,

wobei R, R*, $R_1$, $R_1^*$ und $R_2$ aromatische Gruppierungen sind und bezüglich $n_1$, $n_2$ und $n_3$ folgendes gilt:
$n_1$ = 1 bis 100, $n_2$ und $n_3$ = 0, oder
$n_1$ und $n_2$ = 1 bis 100, $n_3$ = 0, oder
$n_1$, $n_2$ und $n_3$ = 1 bis 100 (mit $R \neq R^*$ und/oder $R_1 \neq R_1^*$ ), oder $n_1$ und $n_3$ = 1 bis 100, $n_2$ = 0 (mit $R \neq R^*$ und/oder $R_1 \neq R_1^*$ ).

6. Lichtempfindliches Gemisch nach Anspruch 1 oder 2, **dadurch gekennzeichnet,** daß das Polymere mit phenolischen Hydroxylgruppen ein Hydroxypolyimid folgender Struktur ist:

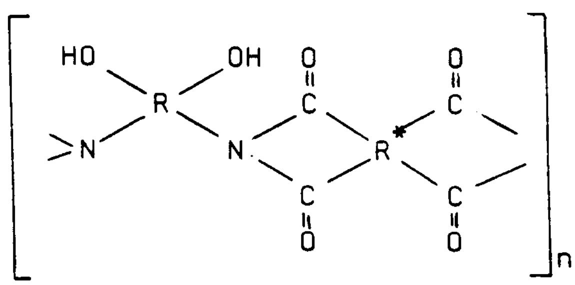 ,

wobei R und R* aromatische Gruppierungen sind, die gleich oder verschieden sein können, und für n folgendes gilt:
n = 2 bis 100.

7. Lichtempfindliches Gemisch nach einem der Ansprüche 1 bis 6, **dadurch gekennzeichnet,** daß das Masseverhältnis von Polymer zu photoaktiver Komponente zwischen 20:1 und 1:20 liegt, vorzugsweise zwischen 10:1 und 1:10.

8. Verfahren zur Herstellung von Reliefstrukturen, **dadurch gekennzeichnet,** daß ein lichtempfindliches Gemisch nach einem oder mehreren der Ansprüche 1 bis 7 in Form einer Schicht oder Folie auf ein Substrat aufgebracht und mit aktinischem Licht durch eine Maske belichtet oder durch Führen eines entsprechenden Lichtstrahls bestrahlt wird, daß die belichteten bzw. bestrahlten Schicht- oder Folienteile herausgelöst oder abgezogen und die dabei erhaltenen Strukturen bei erhöhter Temperatur getrocknet und gegebenenfalls getempert werden.

9. Verfahren nach Anspruch 8, **dadurch gekennzeichnet,** daß das lichtempfindliche Gemisch als Lösung in einem organischen Lösungsmittel auf das Substrat aufgebracht wird.

10. Verfahren nach Anspruch 8 oder 9, **dadurch gekennzeichnet,** daß ein Haftvermittler und/oder ein Benetzungsmittel verwendet wird.

## Claims

1. Photosensitive mixture comprising a polymer and a photoactive component, characterised in that the polymer has carboxylic acid anhydride groups or phenolic hydroxyl groups and in that the photoactive

component is an N-substituted 1,4-dihydropyridine or 1,4-dihydropyridine derivative of the following structure:

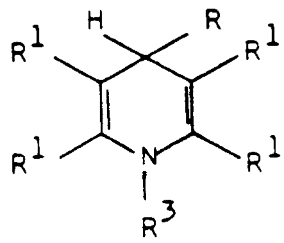

where the $R^1$ groups are the same or different and are defined as follows:

$R^1$ = H, $(CH_2)_n$-$CH_3$, OH, O-$(CH_2)_n$-$CH_3$, $(CF_2)_n$-$CF_3$, $C_6H_5$, O-$C_6H_5$, COOH, COO-$(CH_2)_n$-$CH_3$, CO-$(CH_2)_n$-$CH_3$, $(CH_2)_n$-O-$(CH_2)_m$-$CH_3$, $(CH_2)_n$-OH, $(CH=CH)_p$-CO-$CH_3$, F, Cl, Br, or I, with m = 0 to 10, n = 0 to 10 and p = 1 to 4,

or one of the two pairs of ortho positioned groups $R^1$ is a constituent of an aromatic or olefinically unsaturated six-membered ring; and the following applies for the R group:

R =

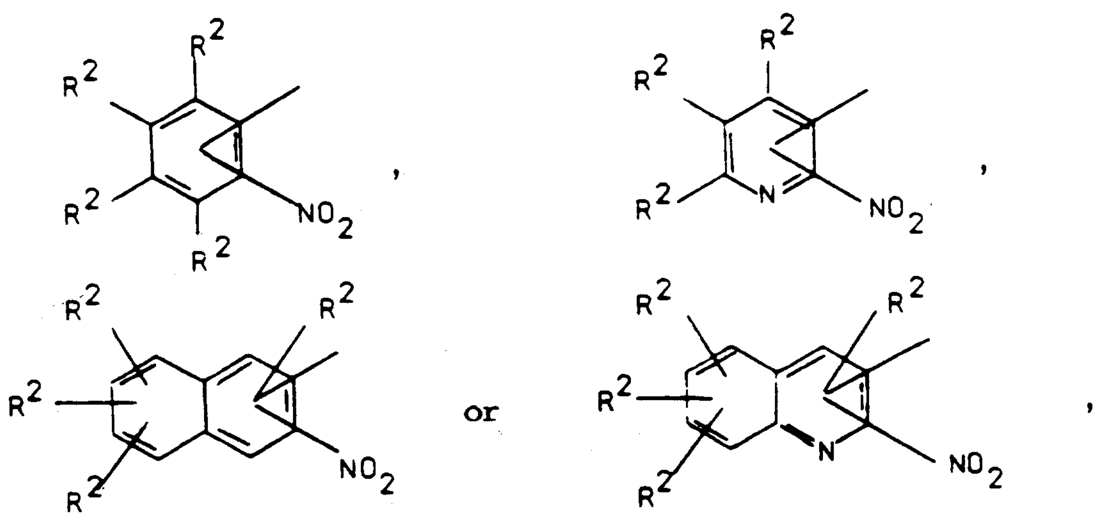

, , or ,

where the $NO_2$-group is always arranged in the ortho position to the bond to the dihydropyridine ring and the $R^2$ groups are the same or different and are defined as follows:

$R^2$ = H, $(CH_2)_n$-$CH_3$, OH, O-$(CH_2)_n$-$CH_3$, $(CF_2)_n$-$CF_3$, $C_6H_5$, O-$C_6H_5$, COOH, COO-$(CH_2)_n$-$CH_3$, CO-$(CH_2)_n$-$CH_3$, $(CH_2)_n$-O-$(CH_2)_m$-$CH_3$, $(CH_2)_n$-OH, $NO_2$, F, Cl, Br, or I, with m = 0 to 10 and n = 0 to 10; and

$R^3$ signifies alkyl with 1 to 7 C-atoms or - optionally substituted - cyclohexyl and phenyl.

**2.** Photosensitive mixture according to claim 1, characterised in that the photoactive component is an N-substituted 4-(2'-nitrophenyl)-1,4-dihydropyridine or a corresponding derivative of the following structure:

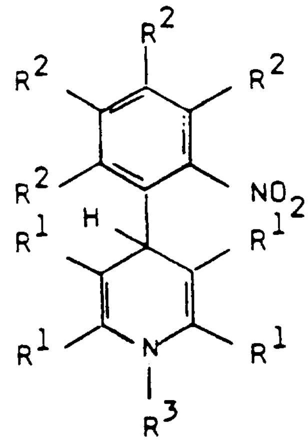

,

where the $R^1$ and $R^2$ groups are the same or different and the $R^1$, $R^2$ and $R^3$ groups are defined as specified above.

**3.** Photosensitive mixture according to claim 1 or 2, characterised in that the polymer with carboxylic acid anhydride groups has the following structure:

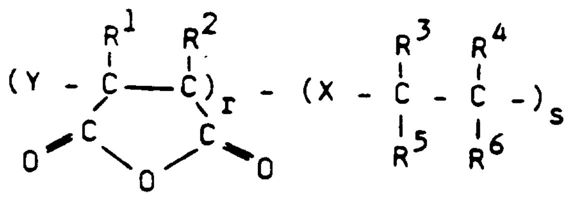

,

where the following applies:
$r / r + s = 0$ to 0.6 and $r + s = 4$ to 3000;
X and Y are the same or different and stand for a single bond or for -COO-, -CONH-, -CONHNH-, -OCOO-, -O-, $-SO_2-$ and -COOCO-;
the $R^1$, $R^2$, $R^3$, $R^4$, $R^5$ and $R^6$ groups are the same or different and are defined as follows:
H, $(CH_2)_n-CH_3$, $C_6H_5$, COOH, $COO-(CH_2)_n-CH_3$, $CO-(CH_2)_n-CH_3$, $Si[(CH_2)_n-CH_3]_3$, $Si(C_6H_5)_3$, $CH_2-Si-(CH_3)_3$, $Si(OCH_3)_3$, $C_6H_4-OH$, $C_6H_4-(CH_2)_n-CH_3$, $C_6H_4-O-(CH_2)_n-CH_3$ and $(CH_2)_n-O-(CH_2)_m-CH_3$,
with $m = 0$ to 10 and $n = 0$ to 10;
$R^1$ and $R^2$ or $R^3$ and $R^4$ or $R^5$ and $R^6$ can also be linked together cyclically aliphatically or aromatically.

**4.** Photosensitive mixture according to claim 1 or 2, characterised in that the polymer with phenolic hydroxyl groups is a phenol formaldehyde condensation product of the following structure:

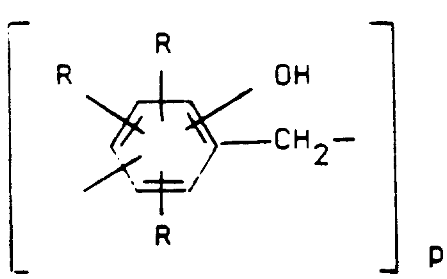

,

where the following applies:
p = 10 to 10000,
R = H, $(CH_2)_m-OH$, $(CH_2)_n-CH_3$, OH, $O-(CH_2)_n-CH_3$, $C_6H_5$ or halogen,
with $m = 1$ to 10 and $n = 0$ to 10.

**5.** Photosensitive mixture according to claim 1 or 2, characterised in that the polymer with phenolic hydroxyl groups is a hydroxy polyamide of the following structure:

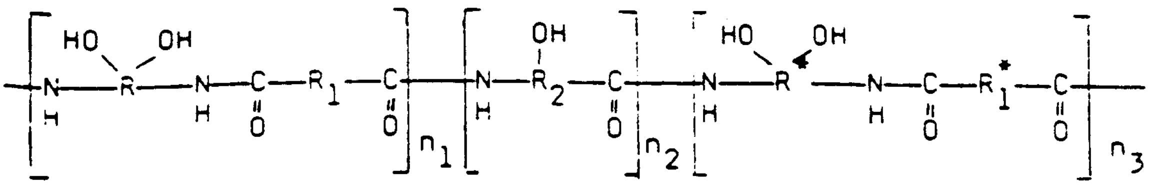

where R, R*, $R_1$, $R_1^*$ and $R_2$ are aromatic groupings and with respect to $n_1$, $n_2$ and $n_3$ the following applies:
$n_1$ = 1 to 100, $n_2$ and $n_3$ = 0, or
$n_1$ and $n_2$ = 1 to 100, $n_3$ = 0, or
$n_1$, $n_2$ and $n_3$ = 1 to 100 (with R ≠ R* and/or $R_1 \neq R_1^*$ ), or $n_1$ and $n_3$ = 1 to 100, $n_2$ = 0 (with R ≠ R* and/or $R_1 \neq R_1^*$ ).

**6.** Photosensitive mixture according to claim 1 or 2, characterised in that the polymer with phenolic hydroxyl groups is a hydroxy polyimide of the following structure:

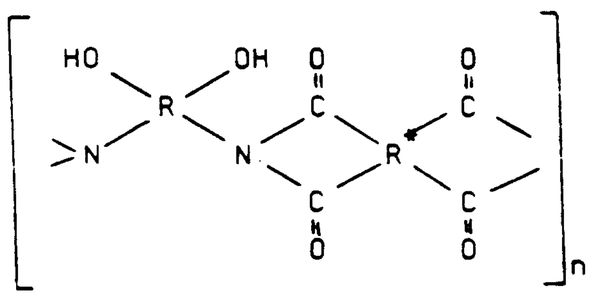

where R and R* are aromatic groupings, which can be the same or different, and the following applies for n:
n = 2 to 100.

**7.** Photosensitive mixture according to one of the claims 1 to 6, characterised in that the mass ratio of the polymer to the photoactive component is from 20:1 to 1:20, preferably from 10:1 to 1:10.

**8.** Method for producing relief structures, characterised in that a photosensitive mixture according to one or several of the claims 1 to 7 is deposited in the form of a layer or foil on a substrate and is exposed to actinic light through a mask or is irradiated by guiding an appropriate light beam, in that the exposed or irradiated layer or foil portions are extracted or drawn off and the structures thereby obtained are dried and optionally tempered at an elevated temperature.

**9.** Method according to claim 8, characterised in that the photosensitive mixture is deposited as a solution in an organic solvent on the substrate.

**10.** Method according to claims 8 or 9, characterised in that an adhesion promoter and/or a wetting agent is used.

**Revendications**

**1.** Mélange photosensible d'un polymère et d'un constituant photoactif, caractérisé en ce que le polymère comporte des groupes anhydrides d'acide carboxylique ou hydroxyle phénoliques, et en ce que le constituant photoactif est une 1,4-di-hydropyridine substituée sur l'azote ou un dérivé de 1,4-dihydropyridine substituée sur l'azote de structure suivante :

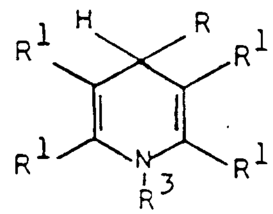

dans laquelle les radicaux $R^1$ sont identiques ou différents et ont la signification suivante :

$R^1$ = H, $(CH_2)_n$-$CH_3$, OH, O-$(CH_2)_n$-$CH_3$, $(CF_2)_n$-$CF_3$, $C_6H_5$, O-$C_6H_5$, COOH, COO-$(CH_2)_n$-$CH_3$, CO-$(CH_2)_n$-$CH_3$, $(CH_2)_n$-O-$(CH_2)_m$-$CH_3$, $(CH_2)_n$-OH, $(CH=CH)_p$-CO-$CH_3$, F, Cl, Br ou I, avec m = 0 à 10, n = 0 à 10 et p = 1 à 4,

ou l'un des deux couples de radicaux $R^1$ en position ortho fait partie d'un cycle à six chaînons aromatique ou à insaturation oléfinique,

et le radical R est le suivant :

R =

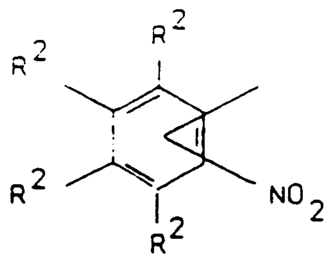

,

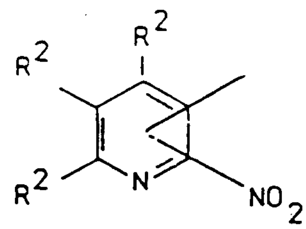

,

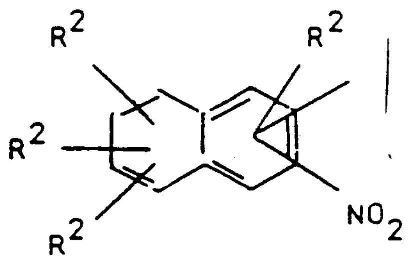

ou

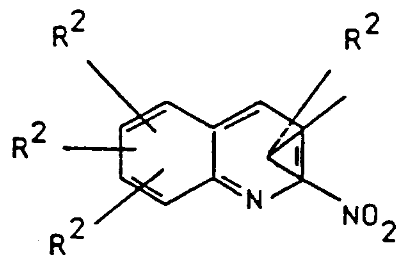

dans lesquelles le groupe $NO_2$ est toujours en position ortho de la liaison au cycle dihydropyridine et les radicaux $R^2$ sont identiques ou différents et ont la signification suivante :

$R^2$ = H, $(CH_2)_n$-$CH_3$, OH, O-$(CH_2)_n$-$CH_3$, $(CF_2)_n$-$CF_3$, $C_6H_5$, O-$C_6H_5$, COOH, COO-$(CH_2)_n$-$CH_3$, CO-$(CH_2)_n$-$CH_3$, $(CH_2)_n$-O-$(CH_2)_m$-$CH_3$, $(CH_2)_n$-OH, $NO_2$, F, Cl, Br ou I, avec m = 0 à 10 et n = 0 à 10, et

$R^3$ signifie alcoyle ayant de 1 à 7 atomes de carbone ou cyclohexyle et phényle éventuellement substitué.

**2.** Mélange photosensible suivant la revendication 1, caractérisé en ce que le constituant photoactif est une 4-(2'-nitrophényl)-1,4-dihydropyridine substituée sur l'azote ou un dérivé correspondant ayant la structure suivante :

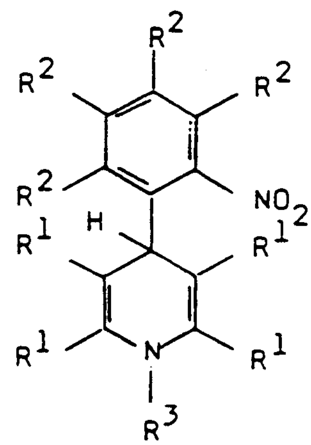

les radicaux $R^1$ ou $R^2$ étant identiques ou différents et les radicaux $R^1$, $R^2$ et $R^3$ ayant les significations indiquées ci-dessus.

3. Mélange photosensible suivant la revendication 1 ou 2, caractérisé en ce que le polymère ayant des groupes anhydrides d'acide carboxylique a la structure suivante

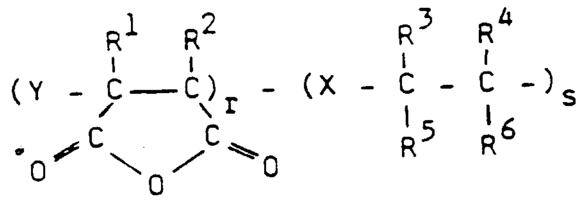

dans laquelle :
$r / r + s = 0$ à 0,6 et $r + s = 4$ à 3000;
X et Y sont identiques ou différents et représentent une liaison simple ou -COO-, -CONH-, CONHNH-, -OCOO-, -O-, $-SO_2$-et -COOCO-;
les radicaux $R^1$, $R^2$, $R^3$, $R^4$, $R^5$ et $R^6$ sont identiques ou différents et ont la signification suivante :
H, $(CH_2)_n$-$CH_3$, $C_6H_5$, COOH, COO-$(CH_2)_n$-$CH_3$, CO-$(CH_2)_n$-$CH_3$, Si[$(CH_2)_n$-$CH_3$]$_3$, Si$(C_6H_5)_3$, $CH_2$-Si-$(CH_3)_3$, Si$(OCH_3)_3$, $C_6H_4$-OH, $C_6H_4$-$(CH_2)_n$-$CH_3$, $C_6H_4$-O-$(CH_2)_n$-$CH_3$ et $(CH_2)_n$-O$(CH_2)_m$-$CH_3$, avec m = 0 à 10 et n = 0 à 10;
$R^1$ et $R^2$ ou $R^3$ et $R^4$ ou $R^5$ et $R^6$ peuvent également être reliés l'un à l'autre de manière cyclique, aliphatique ou aromatique.

4. Mélange photosensible suivant la revendication 1 ou 2, caractérisé en ce que le polymère ayant des groupes hydroxyle phénoliques est un produit de condensation phénolformaldéhyde de structure suivante

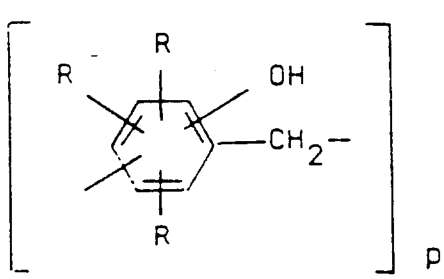

dans laquelle :
p = 10 à 10000,

R = H, $(CH_2)_m$-OH, $(CH_2)_n$-$CH_3$, OH, O-$(CH_2)_n$-$CH_3$, $C_6H_5$ ou halogène, avec m = 1 à 10 et n = 0 à 10.

**5.** Mélange photosensible suivant la revendication 1 ou 2, caractérisé en ce que le polymère ayant des groupes hydroxyle phénoliques est un hydroxypolyamide de structure suivante

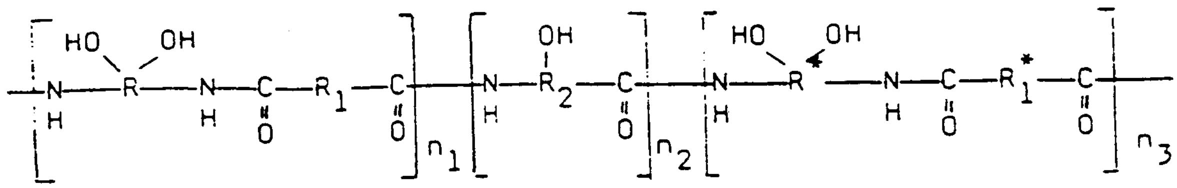

dans laquelle R, R*, $R_1$, $R_1$* et $R_2$ sont des groupements aromatiques et pour $n_1$, $n_2$ et $n_3$, on a :
$n_1$ = 1 à 100, $n_2$ et $n_3$ = 0, ou
$n_1$ et $n_2$ = 1 à 100, $n_3$ = 0, ou
$n_1$, $n_2$ et $n_3$ = 1 à 100 (avec R ≠ R* et/ou $R_1$ ≠ $R_1$*), ou $n_1$ et $n_3$ = 1 à 100, $n_2$ = 0 (avec R ≠ R* et/ou $R_1$ ≠ $R_1$*.

**6.** Mélange photosensible suivant la revendication 1 ou 2, caractérisé en ce que le polymère ayant des groupes hydroxyle phénoliques est un hydroxypolyimide de structure suivante :

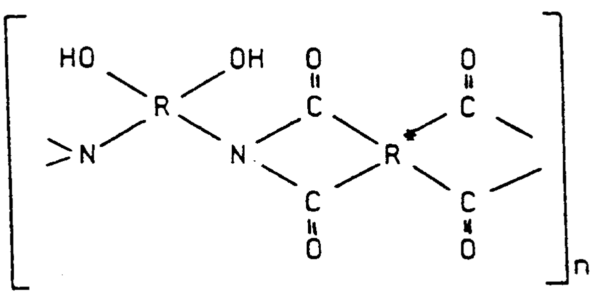

dans laquelle R et R* sont des groupements aromatiques qui peuvent être identiques ou différents et pour n on a ce qui suit :
n = 2 à 100.

**7.** Mélange photosensible suivant l'une des revendications 1 à 6, caractérisé en ce que le rapport en masse du polymère au constituant photoactif est compris entre 20:1 et 1:20 et, de préférence, entre 10:1 et 1:10.

**8.** Procédé d'obtention de structures en relief, caractérisé en ce qu'il consiste à déposer un mélange photosensible suivant l'une ou plusieurs des revendications 1 à 7 sous la forme d'une couche ou d'une feuille sur un substrat et à l'exposer à travers une réserve à de la lumière actinique ou à le soumettre à un rayonnement par envoi d'un rayonnement lumineux adéquat, à dissoudre ou à enlever les parties de couches ou de feuilles exposées ou soumises à un rayonnement et à sécher et éventuellement à recuire, à haute température, les structures ainsi obtenues.

**9.** Procédé suivant la revendication 8, caractérisé en ce qu'il consiste à déposer le mélange photosensible sur le substrat sous la forme d'une solution dans un solvant organique.

**10.** Procédé suivant la revendication 8 ou 9, caractérisé en ce qu'il consiste à utiliser un agent adhésif et/ou un agent de mouillage.